# EUROPEAN PATENT SPECIFICATION

(11) **EP 3 796 230 B1**
(45) Date of publication and mention of the grant of the patent: **09.03.2022**
(21) Application number: 19197794.1
(22) Date of filing: 17.09.2019
(51) Int. Cl.: G06N 3/04, G06N 3/08, G06T 7/00, G03F 7/20

(54) **A METHOD FOR DETERMINING PROCESS LIMITS OF A SEMICONDUCTOR PROCESS**
VERFAHREN ZUR BESTIMMUNG VON PROZESSGRENZEN EINES HALBLEITERPROZESSES
MÉTHODE PERMETTANT DE DÉTERMINER LES LIMITES DE PROCÉDÉ D'UN PROCÉDÉ SEMI-CONDUCTEUR

(43) Date of publication of application: 24.03.2021
(73) Proprietor: Imec VZW, 3001 Leuven (BE)
(72) Inventor: Halder, Mr. Sandip, 3001 Leuven (BE); Dey, Mr. Bappaditya, 3001 Leuven (BE); Cerbu, Mr. Dorin, 3001 Leuven (BE)
(74) Representative: Patent Department IMEC

(56) References cited:
- WO-A1-2017/117568
- US-A1- 2019 033 838
- US-A1- 2019 214 285
- TULALA PETER ET AL: "Unsupervised Wafermap Patterns Clustering via Variational Autoencoders", 2018 INTERNATIONAL JOINT CONFERENCE ON NEURAL NETWORKS (IJCNN), IEEE, 8 July 2018 (2018-07-08), pages 1-8, XP033419231, DOI: 10.1109/IJCNN.2018.8489422 [retrieved on 2018-10-10]

## Description

### Field of the Invention

The present invention is related to semiconductor processing and in particular to the determination of process limits for one or more parameters, such as the exposure dose and focus applied in a lithography process.

### State of the art.

A semiconductor device such as an integrated circuit chip is produced by a sequence of hundreds of process steps. Many of them require a lithographic mask through which a two-dimensional pattern is imprinted on a photoresist layer, followed by one or more etch processes for producing the pattern in the form of three-dimensional features formed in the material of a semiconductor wafer or of layers on the wafer. The design of such lithographic masks nowadays involves the prediction of the printed pattern taking into account optical, resist and etch phenomena, which occur at the scale of the mask features and below. These effects cause unavoidable deviations on the printed pattern with respect to the design intent. So-called 'Electronic Design Automation' (EDA) tools, such as 'Optical Proximity Correction' (OPC) software is used for determining and making corrections to the intended initial mask design to give the best possible approximation of the design intent on the printed wafer. OPC optimization is based on the fragmentation of the initial design edges to compensate for the given phenomena, and relies on an accurate modelling to predict simulated contours of the printed features. The review of the OPC-based solution is conducted by outputting a simulated printable window of many features. The window defines the printability performance limits in terms of the focus and exposure dose settings of a lithographic tool, within which limits a reliable print of the pattern is obtainable. Some patterns can have bigger printable windows than other patterns, due to various reasons such as design geometry, accuracy of the OPC modelling, and more.

The simulated windows are subsequently verified experimentally by manufacturing a test mask and using it to print various pattern features on a plurality of die areas of a photosensitive resist layer. Each die area is being printed with varying values of the focus and exposure conditions. The experimental windows are determined by measuring features on the plurality of die areas. Differences between the experimental and simulated windows are evaluated and may necessitate further OPC-based optimization of the mask design.

In WO2017/117568, one or more substrates with variation of the process parameters are used for obtaining a dataset of training images of the same portion of different dies. A generative model is trained in order to be used for metrology and defect review which are both useful for process window characterization.

In US2019/033838, process limits for one or more parameters of a semiconductor process are determined by using machine learning.

Different measurement techniques are known for analysing the printed dies. Optical inspection may be used but as the feature dimensions shrink to critical dimensions under 32nm, these techniques are not sufficiently accurate because optical tools cannot resolve the structures. Therefore e-beam tools such as CD-SEM (Critical Dimension-Scanning Electron Microscope) are used to obtain detailed images and the printable window is derived from a manual inspection of these images. This is however a time-consuming effort and it represents a bottleneck that slows down the mask development process.

Within the printable window, a more narrow process window may be determined, related for example to specific defects, i.e. defects which occur when the dose and focus are outside the limits of the process window. The determination of this narrow process window today takes place primarily through the manual comparison of CD-SEM images, and is therefore equally a labour-intensive and time-consuming effort.

The printable window and the defect-related process window are examples of process limits needed for evaluating an OPC based mask design and/or for correctly printing a given set of features on a semiconductor wafer. Process limits are determined not only in terms of dose and focus applied in lithography processes, but also as a function of various other process parameters, such as etch parameters or parameters related to deposition or planarization processes. Today, the determination of these process limits equally requires a primarily manual analysis of CD-SEM images.

In general, the above described problems are related to the difficulty of distinguishing between different images of a die area obtained by a semiconductor process, wherein the different images are obtained by varying one or more process parameters. Especially for the small device dimensions applied today and certainly for even smaller projected dimensions, no reliable technique is available that allows to make this distinction without requiring extensive time and manual effort.

### Summary of the invention

The invention aims to provide a method for determining process limits that does not suffer from the above described problems. This aim is achieved by the method according to the appended claims. According to the invention, a dataset of detailed images of the same die area, preferably CD-SEM images, is taken as the starting point of a method that allows to determine process limits without manual intervention. The images of the dataset correspond to different settings of one or more process parameters, for example different dose and focus settings applied in a lithographic process. One or more images from the dataset are used as training images of an unsupervised generative machine learning algorithm. The algorithm creates a latent vector space, comprising latent vectors that allow the algorithm to synthesize a large quantity of synthetic images. The method then presents one or more images from the dataset as query images to the algorithm, and a score is attributed to a set of object images from the dataset, based on the distances between the query image and respective object images, said distances being determined in the latent vector space. According to the invention, the score is representative of one or more characteristics of the images, such as the critical dimensions of one or more 2 or 3-dimensional features appearing in the images. This allows to extract the process limits directly from the score values, rather than from a manual comparison of the images. Obtaining a score value representative of a given image characteristic is enabled by a targeted choice of one or more of the query images and object images, and/or by determining the score as an aggregate score value, calculated from the scores obtained with respect to a set of different query images. The aggregate score may for example be the maximum or the average of the scores of the object images, obtained with respect to a set of query images.

The invention is in particular related to a method for determining process limits for one or more parameters of a semiconductor process, the method comprising the steps of :
- providing one or more test substrates comprising a plurality of die areas,
- applying the process on different die areas of the one or more test substrates, wherein the one or more process parameters are incremented, starting from a set value of the parameters at one of the die areas, and increasing and/or decreasing the parameter or parameters stepwise in the other die areas,
- obtaining a dataset of images of the same portion of the different die areas, processed by applying different parameter values,
- determining the process limits by a sequence of method steps comprising : creating a latent vector space by training an unsupervised generative machine learning algorithm on the basis of one or more of the images of the dataset,
- selecting one or more query images from the image dataset,
- for each query image, determining the distances in the latent vector space from the query image to a plurality of images from the dataset, the latter plurality of images being referred to hereafter as object images,
- attributing a score to each of said object images, based on the distances between said plurality of object images and the one or more query images, wherein the query images, the object images and the definition of the score are chosen in such a manner that the score is representative of the one or more characteristics of the images, at least in a given range of said one or more characteristics,
- extracting the process limits from the relation between the score and the one or more process parameters.

According to an embodiment, a single query image is selected, and wherein the score is said distance or a linear function thereof.

According to an embodiment, multiple query images are selected, and wherein the score is an aggregate score based on the totality of the scores for each object image. The aggregate score may be the maximum of the scores of each of the object images. According to another embodiment, the aggregate score is the average of the scores of each of the object images.

According to an embodiment, one or more synthetic images, generated by the algorithm, are added to the dataset, and wherein one or more of said synthetic images are used as query images.

According to an embodiment, at least one of the query images and/or at least one of the object images is an outlier image, i.e. an image that does not correspond to values of the one or more characteristics which lie in a predefined range of interest for said one or more characteristics.

The machine learning algorithm may be an algorithm of the type Generative Adversarial Network (GAN) or Variational Auto Encoder (Var-AE).

According to an embodiment, the process is a lithography process, wherein the method is used for determining a printable window in terms of the dose and focus applied in the lithography process, and wherein the limits of the printable window are detected by determining a step in the relation between the score and the dose and/or the focus.

The method may be used for determining a process window for one or more parameters of the process, wherein the process window determination is based on a predefined known relation between the scores and said one or more characteristics of the images. The predefined known relation may be based on one or more calibration steps performed prior to performing the method.

According to an embodiment, the one or more characteristics of the images comprise the critical dimension of one or more 2 or 3 dimensional pattern features appearing in the images.

The invention is equally related to an apparatus for determining process limits in accordance with the method of the invention, the apparatus comprising a computer configured to :
- receive the images of the dataset,
- train the algorithm on the basis of one or more of said images,
- compute the distance in the latent vector space between one or more query images and a plurality of object images,
- compute said score based on said distances,
- extract the process limits.

The invention is equally related to a computer program product applicable in an apparatus according to the invention, and configured to
- receive the images of the dataset,
- train the algorithm on the basis of one or more of said images,
- compute the distance in the latent vector space between one or more query images and a plurality of object images,
- compute said score based on said distances,
- extract the process limits.
when the program product is run on the computer.

### Brief description of the figures

Figure 1 illustrates a typical focus exposure matrix applied on a FEM test wafer, as known in the art.
Figure 2 shows a detail of the FEM wafer, including specific areas of interest for which a process window determination is required.
Figures 3a to 3c show examples of CD-SEM images of a given area of interest, corresponding to different focus and/or exposure settings.
Figure 4 illustrates the relative distances of five images from a CD-SEM image dataset, as determined in a latent vector space derived from the dataset, in accordance with the method of the invention.
Figure 5 expresses the maximum score as a function of the CD values for the five images of figure 4.
Figure 6 is an example of a score distribution on the dies of a FEM wafer, obtained in accordance with the method of the invention.
Figure 7 illustrates that the score distribution of Figure 5 is a reliable representation of the CD values in a subset of FEM dies.

### Detailed description of preferred embodiments of the invention

The invention is described for the case of determining process limits of a lithographic process, in terms of dose and focus windows. The description is however applicable to other processes as well

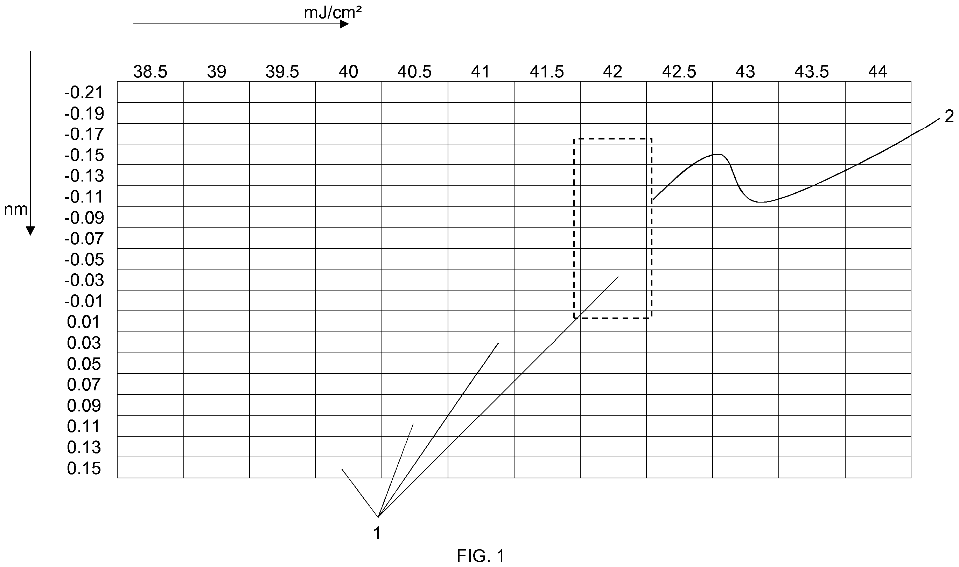

A brief overview is first given of the method for determining a printable window of a lithographic process as it is done today. Figure 1 shows an example of a focus-exposure matrix as applied on a focus-exposure matrix test wafer (FEM wafer). A plurality of dies 1 is distributed across the area of the wafer, and the same patterns are printed in a lithographic tool on each of the dies, and with different lithographic parameters. The columns correspond to respective incremented values of the exposure dose applied in the lithographic tool, expressed in mJ/cm². The rows correspond to respective incremented focus values, i.e. deviations from a pre-defined zero-defocus setting on the exposure tool, expressed in nm. Often the dies are not printed for the extreme values of both focus and dose settings, i.e. the dies in the four corners of the matrix. This results in about 200 to 250 dies, each die corresponding to a different focus-exposure setting.

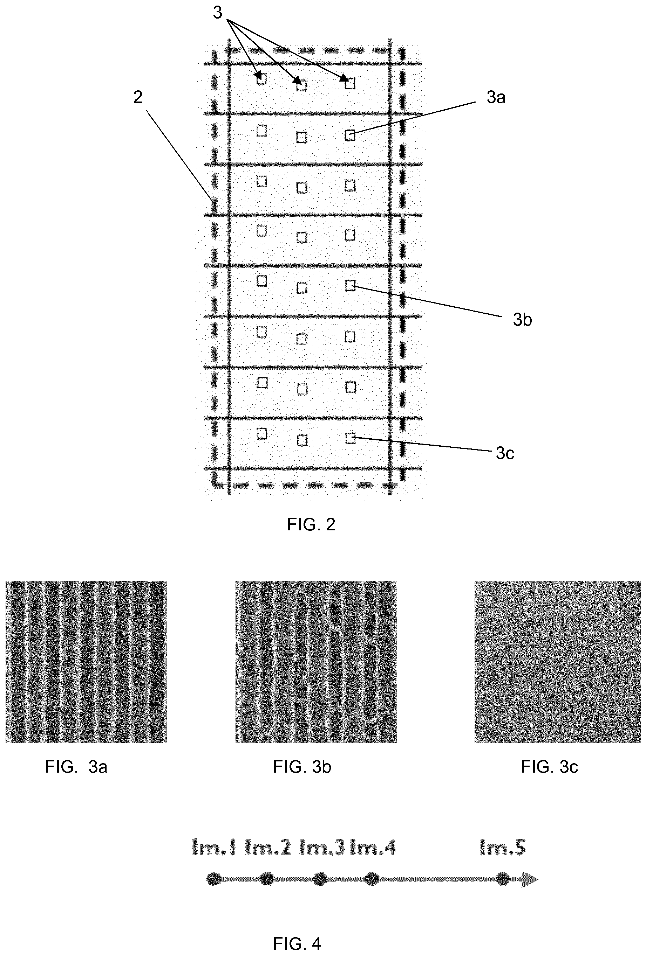

The wafer portion 2 indicated in figure 1 is shown in an enlarged view in figure 2, after printing the FEM wafer in a lithographic tool, at the various settings. Multiple pattern areas 3 on the die are examined, in order to determine the printable window in terms of the exposure and focus parameters, i.e. the ranges of exposure dose and focus within which the feature patterns as designed in these areas are effectively reproduced. For this purpose, CD-SEM images are taken of the areas in question.

Figures 3a to 3c illustrate CD-SEM images of a particular area comprising a set of parallel line features, and printed with different dose and/or focus settings. The images could for example originate from the areas 3a, 3b and 3c indicated in Figure 2. It is clear that the dose and focus settings for the image in figure 3a are better than those of the images shown in figures 3b and 3c. The challenge in the printable window determination and in the defect-related process window determination is however to find the transition between acceptable and non-acceptable dose and focus settings. At present, this requires the manual inspection of the images, including the measurement of critical dimensions of one or more of the printed features, i.e. the width of the line features in the case of the example shown in figures 3a to 3c, and the ranking of the images as a function of the CD values. In many cases, the printable window is linked to a step in the graph that sets out the CD as a function of dose and/or focus, i.e. a sudden rise or fall of the CD-curve.

The present invention provides a way of automatically detecting the printable window. One or more of the CD-SEM images are used as training images for an unsupervised machine learning algorithm that creates a latent vector space on the basis of a pixel-by-pixel analysis of the training images. For example, if each of the images consist of an array of 256 by 256 pixels, each pixel may be attributed a value and a probability distribution, preferably a unit Gaussian. During the learning phase, the algorithm transforms these data into a latent vector space through a neural network. The algorithm learns by a self-correcting sequence of image-synthesis and comparison to the training images, and thereby creates a large number of synthesized images, each image being defined by the values of its specific n-dimensional latent vector.

Machine learning algorithms of the type described above are known per se. An algorithm suitable for the invention may be referred to generally as an unsupervised generative machine learning algorithm. Known examples of this type are the GAN algorithm (Generative Adversarial Network) or the Var-AE (Variational Auto-Encoder). The algorithm is 'generative' in that is able to create synthetic images during the learning phase. This is not the case for example for a normal auto-encoder network. The variational auto-encoder however does have the ability to generate synthetic images.

The steps of the method of the invention will be described for the case of a FEM wafer containing 200 printed dies and for the area shown in figures 3a to 3c. So the dataset contains 200 CD-SEM images of this area, ranging from 'good' (as in figure 3a), through 'average' (as in figure 3b), to 'bad' (as in figure 3c).

According to a preferred embodiment, all of the 200 CD-SEM images are used as training images for the algorithm used in the method of the invention. The learning step may also use less than the full dataset, and may even use one single (preferably good to relatively good) image, because the algorithm will in any case create thousands of synthetic images, ranging from 'good' to 'bad'. However, the more images that are used as training images, the higher the number of synthetic images and the more densely populated is the latent vector space that is created by the learning step. Once the latent vector space is created, the next step in the method of the invention is the attributing of a score to all or to a subset of the 200 images of the dataset. The score is a numeric value that is derived from a comparison of the images in the latent vector space. In other words, the images from the dataset are encoded into the latent vector space, i.e. the synthetic images are determined which approximate as closely as possible the actual CD-SEM images, and the respective latent vectors are compared.

According to a first embodiment of the invention, this is done by selecting a single query image from the dataset, and comparing the query image to a set of other images from the dataset. These images will be referred to hereafter as 'object images'. The comparison is based on the distance in the latent vector space between the query image and the respective object images. The distance is the Euclidean distance between two n-dimensional latent vectors in the vector space. A score is attributed to the object images. The score is representative of the respective distances in the latent vector space, from the query image to the object images. The score may be the distance as such or any linear function of the distance. For example, the distance may be divided by a constant to obtain a normalized value of the distance, so that all scores are between 0 and 1.

When the query image is chosen judiciously, the score of the object images exhibits a monotonic relation to one or more characteristics of the images, for example the critical dimension (i.e. the width) of the parallel lines appearing in the images. In other words, the higher the CD, the higher the score and the lower the CD, the lower the score or vice versa (the higher the CD, the lower the score and the lower the CD, the higher the score). This means that the score or its negative exhibits the same or similar behaviour as a function of dose and focus as the CD. Hence the printable window can be derived from the score values, without necessitating the actual CD-measurements, by detecting the presence of a step in the relation between the score and the focus and/or dose.

The judicious choice' of the query image is illustrated by an example. The example is not necessarily based on the particular images shown in Figures 3a to 3c, but it is applicable to any set of images that include at least one feature defined by a critical dimension. A subset of five CD-SEM images from the image dataset is selected. The five images may for example correspond to the same dose value and to five different focus values. Figure 4 illustrates the relative distances between the five images in the latent vector space. Table 1 expresses the distances relative to image 1, as well as the CD value (expressed in nm), i.e. the critical dimension of a given feature, for the five images. The distance is expressed in dimensionless unit values.

**Table 1**

| Image N° | CD | Distance to image 1 |
|---|---|---|
| 1 | 10 | 0 |
| 2 | 15 | 1 |
| 3 | 20 | 2 |
| 4 | 25 | 3 |
| 5 | 40 | 6 |

It is now possible to take each of the five images as the query image and attribute a score to the five images regarded as object images. When the score is taken to be the distance itself, this results in the scores shown in table 2.

**Table 2**

| | Object images -> | Image 1 | Image 2 | Image 3 | Image 4 | Image 5 |
|---|---|---|---|---|---|---|
| Query images ↓ | | | | | | |
| Image 1 | | 0 | 1 | 2 | 3 | 6 |
| Image 2 | | 1 | 0 | 1 | 2 | 5 |
| Image 3 | | 2 | 1 | 0 | 1 | 4 |
| Image 4 | | 3 | 2 | 1 | 0 | 3 |
| Image 5 | | 6 | 5 | 4 | 3 | 0 |

The distance from a given object image to itself is zero, the other scores are derived from the relative distances illustrated in figure 4. When image 1 is taken as the query image, the scores exhibit a monotonic relation to the CDs. The same is true for the choice of image 5 as the query image. When images 2, 3 or 4 are chosen however, there is no monotonic relation. Clearly it is only images 1 and 5 which are judicious choices' for the query image.

The choice of a single query image may therefore be a difficult task when a full dataset of about 200 images is considered. According to a preferred embodiment, this problem is addressed by attributing the scores not on the basis of the comparison to a single query image, but on the basis of the comparisons to multiple query images. Returning to the example of the five images shown in figure 4 and with reference to table 1, it is clear that the CD for image 5 is far removed from the other images. This is in other words an outlier from the range of 10 to 25 nm in which the majority of the images are situated. Table 3 reprises table 2 but adds one row at the bottom, expressing the maximum scores of each column.

**Table 3**

| | Object images -> | Image 1 | Image 2 | Image 3 | Image 4 | Image 5 |
|---|---|---|---|---|---|---|
| Query images ↓ | | | | | | |
| Image 1 | | 0 | 1 | 2 | 3 | 6 |
| Image 2 | | 1 | 0 | 1 | 2 | 5 |
| Image 3 | | 2 | 1 | 0 | 1 | 4 |
| Image 4 | | 3 | 2 | 1 | 0 | 3 |
| Image 5 | | 6 | 5 | 4 | 3 | 0 |
| **Maximum score** | | **6** | **5** | **4** | **3** | **6** |

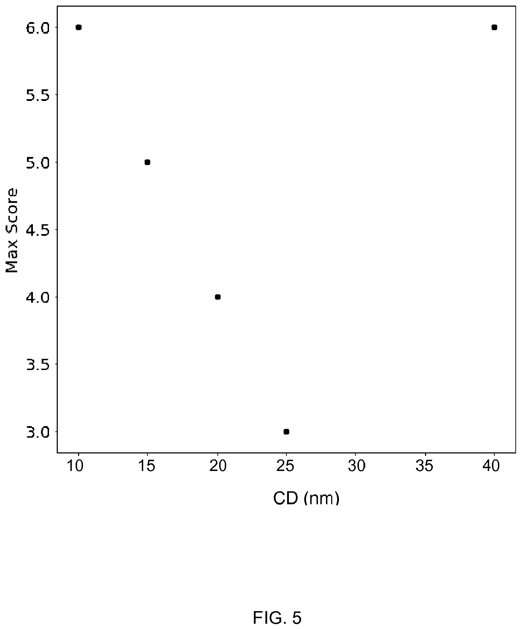

The relation between the maximum scores and the CD is shown in Figure 5. It is clear that in the range of realistic CD values 10-25, i.e. when image 5 is taken out of the equation, the maximum score exhibits a monotonic, in this case linear relation to the CD. Therefore, the maximum score is a suitable 'aggregate score' value, i.e. a score value based on the comparison of object images 1 to 5 to multiple query images, given that the outlier image 5 is in any case not related to a realistic CD.

It is nevertheless the presence *as such* of the outlier image 5 in the score table that ensures the monotonic behaviour of the maximum score in the range of interest. Therefore, according to the preferred embodiment, multiple images are used as query images, and at least one of the query images is an outlier image, i.e. an image for which it is known that it does not correspond to a CD value (or the value of another characteristic) within a predefined range of interest.

The choice of the maximum score as the 'aggregate' score is one example of how the aggregate score is defined. Another possibility is taking the average of the scores of each column. Still other ways to define the aggregate score are included in the scope of the invention. What is needed is an aggregate score that behaves in a monotonic way for a sequence of images for which it is known that the CD (or another characteristic of the images) equally behaves monotonically in a given range of interest. If this is the case, the aggregate score will exhibit the same or very similar behaviour as the actual CD or other characteristic, as a function of dose and focus, and will therefore allow to extract a printable window.

The score table as shown in tables 2 and 3 may be drawn up for the totality of the dataset, i.e. each of the 200 images is taken as the query image and each of the images is 'scored' as an object image relative to itself and to the other 199 images. The number of query images may however be smaller than the number of object images. For example, the full set of 200 images may be 'scored' in relation to a smaller number, for example 50, query images. On the other hand, the dataset may be expanded by adding one or more synthetic images to it, for example a number of synthetic images for which it is known that they correspond to outlier images, and these synthetic images may be added to the list of query images in the first column of the table, and possibly also to the list of object images. This may help to obtain an aggregate score that corresponds well with the CD in the range of interest.

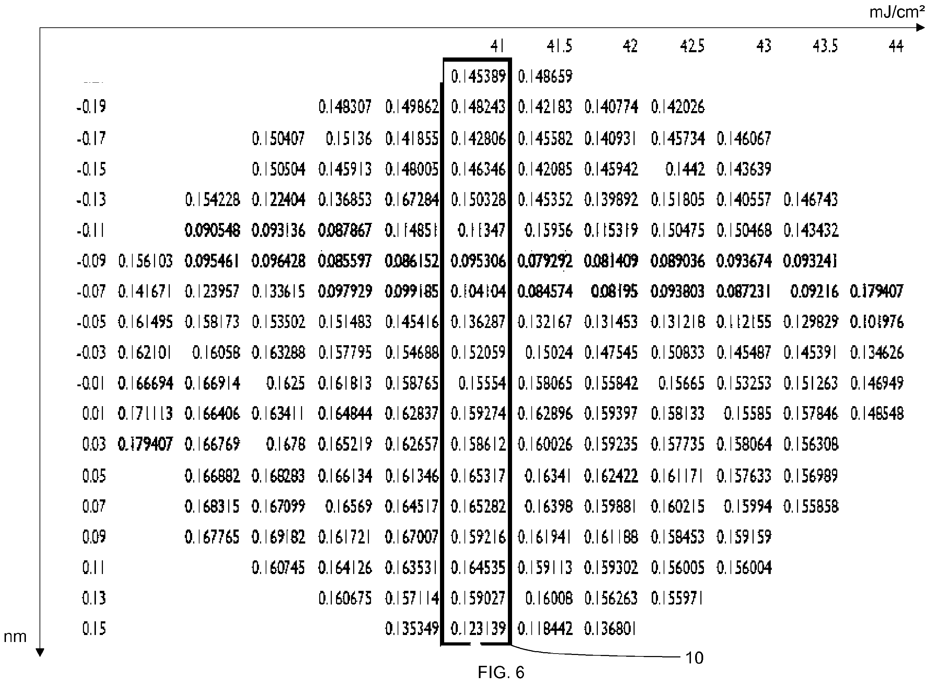

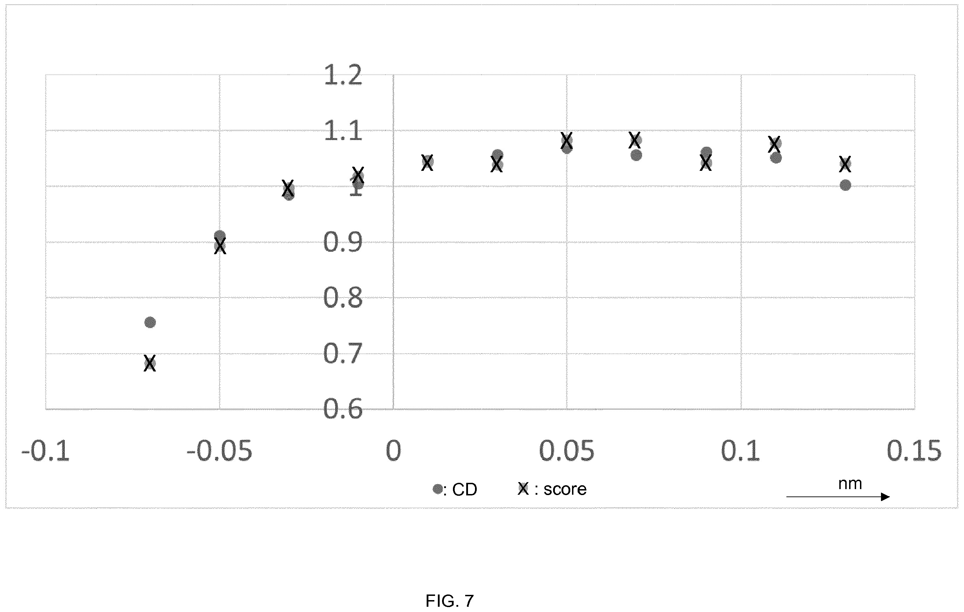

Figure 6 shows an example of a score distribution obtained by the method of the invention, on the dies of a FEM wafer. Each number represents a score obtained in the above-described way, and wherein the query images, the object images and the definition of the aggregate score are chosen in such a way that the aggregate score behaves in the same way as the actual CD of a feature in the respective images. This is illustrated by the graph in Figure 7, which shows normalized values of the CD and of the score relative to the same scale, as a function of the focus and for a dose setting of 41mJ/cm², i.e. for the values of the column 10 highlighted in Figure 6. The values of the CD and of the scores are normalized to the same dimensionless value. It is clear that the scores follow the behaviour of the CD accurately. In particular, the sharp rise of the CD on the lefthand side of the graph is clearly reflected by the score values. This sharp rise identifies the edge of the printable window, which can therefore be identified on the basis of the score values alone, i.e. from the shape of the graph that relates the score on the Y-axis to the focus or dose on the X-axis.

It is seen that the scores furthermore closely follow the variations of the CD beyond the sharp rise. This result shows that it is possible to determine a CD-related process-window (i.e. a more narrow window within the limits of the printable window) on the basis of the score values alone, provided a preliminary calibration is performed. The calibration could entail the measurement of CDs on a limited number of images and the determination of a scale factor that allows to estimate the CD from the score values, possibly applying different scale factors in different ranges along the focus or dose axis, or determining a more intricate function that links the scores to the CD values. This allows to reconstruct the CDs from the scores, and to determine directly a CD-based process window from the score graph, without necessitating the manual inspection of a large number of CD-SEM images.

It is clear to the skilled reader that the above-described method is applicable to any set of images related to different parameter settings of any semiconductor process, not only of a lithographic process. Also, the characteristic of the images that is linked to the score may be another characteristic instead of a CD value, even though the CD is obviously a good choice. The power of the method however lies in the fact that the synthetic images in the latent vector space embody essentially any characteristic of the images, such as differences in illumination or sharpness. The ranking of images takes place on the basis of the distances in the latent vector space, and thereby implicitly takes into account all these characteristics. By finding a score that is representative of a characteristic, the graph of the score as a function of the process parameter can reveal process limits which would otherwise require the manual comparison of images.

The above described method for determining process limits can be executed in a computer-implemented manner, in an apparatus comprising a computer configured to :
- receive the images of the dataset,
- train the algorithm on the basis of one or more of said images,
- compute the distance in the latent vector space between one or more query images and a plurality of object images,
- compute said score based on said distances,
- extract the process limits.

The invention is therefore also related to such an apparatus and to a computer program product applicable in such an apparatus. The latter is a software product that includes the machine learning algorithm and that may further allow the user to perform a number of actions, such as the selection of training images, query images and object images, or the definition of the score. The software may also be configured to apply some of these actions automatically according to predefined selection and calculation criteria.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A method for determining process limits for one or more parameters of a semiconductor process, the method comprising the steps of:
- providing one or more test substrates comprising a plurality of die areas (1),
- applying the process on different die areas of the one or more test substrates, wherein the one or more process parameters are incremented, starting from a set value of the parameters at one of the die areas, and increasing and/or decreasing the parameter or parameters stepwise in the other die areas,
- obtaining a dataset of images (3a,3b,3c) of the same portion of the different die areas, processed by applying different parameter values,
- determining the process limits by a sequence of method steps comprising : creating a latent vector space by training an unsupervised generative machine learning algorithm on the basis of one or more of the images of the dataset,
- selecting one or more query images from the image dataset,
- for each query image, determining the distances in the latent vector space from the query image to a plurality of images from the dataset, the latter plurality of images being referred to hereafter as object images,
- attributing a score to each of said object images, based on the distances between said plurality of object images and the one or more query images, wherein the query images, the object images and the definition of the score are chosen in such a manner that the score is representative of the one or more characteristics of the images, at least in a given range of said one or more characteristics,
- extracting the process limits from the relation between the score and the one or more process parameters.

2. The method according to claim 1, wherein a single query image is selected, and wherein the score is said distance or a linear function thereof.

3. The method according to claim 1, wherein multiple query images are selected, and wherein the score is an aggregate score based on the totality of the scores for each object image.

4. The method according to claim 3, wherein the aggregate score is the maximum of the scores of each of the object images.

5. The method according to claim 3, wherein the aggregate score is the average of the scores of each of the object images.

6. The method according to any one of claims 3 to 5, wherein one or more synthetic images, generated by the algorithm, are added to the dataset, and wherein one or more of said synthetic images are used as query images.

7. The method according to any one of the preceding claims, wherein at least one of the query images and/or at least one of the object images is an outlier image, i.e. an image that does not correspond to values of the one or more characteristics which lie in a predefined range of interest for said one or more characteristics.

8. The method according to any one of the preceding claims, wherein the machine learning algorithm is an algorithm of the type Generative Adversarial Network (GAN) or Variational Auto Encoder (Var-AE).

9. The method according to any one of the preceding claims, wherein the process is a lithography process, wherein the method is used for determining a printable window in terms of the dose and focus applied in the lithography process, and wherein the limits of the printable window are detected by determining a step in the relation between the score and the dose and/or the focus.

10. The method according to any one of claims 1 to 8, wherein the method is used for determining a process window for one or more parameters of the process, and wherein the process window determination is based on a predefined known relation between the scores and said one or more characteristics of the images.

11. The method according to claim 10, wherein the predefined known relation is based on one or more calibration steps performed prior to performing the method.

12. The method according to any one of the preceding claims, wherein the one or more characteristics of the images comprise the critical dimension of one or more 2 or 3 dimensional pattern features appearing in the images.

13. An apparatus for determining process limits in accordance with the method according to any one of the preceding claims, the apparatus comprising a computer configured to :
- receive the images of the dataset,
- train the algorithm on the basis of one or more of said images,
- compute the distance in the latent vector space between one or more query images and a plurality of object images,
- compute said score based on said distances,
- extract the process limits.

14. A computer program product applicable in an apparatus according to claim 13, and configured to
- receive the images of the dataset,
- train the algorithm on the basis of one or more of said images,
- compute the distance in the latent vector space between one or more query images and a plurality of object images,
- compute said score based on said distances,
- extract the process limits.
when the program product is run on the computer.

## Patentansprüche

1. Verfahren zum Bestimmen von Prozessgrenzen für einen oder mehrere Parameter eines Halbleiterprozesses, wobei das Verfahren die folgenden Schritte umfasst:
- Bereitstellen eines oder mehrerer Testsubstrate, die eine Vielzahl von Chipbereichen (1) umfassen,
- Anwenden des Prozesses auf verschiedene Chipbereiche des einen oder der mehreren Testsubstrate, wobei der eine oder die mehreren Prozessparameter ausgehend von einem eingestellten Wert der Parameter an einem der Chipbereiche inkrementiert werden und der Parameter oder die Parameter schrittweise in den anderen Chipbereichen erhöht und/oder verringert werden,
- Erhalten eines Datensatzes von Bildern (3a, 3b, 3c) desselben Abschnitts der unterschiedlichen Chipbereiche, die durch Anwenden unterschiedlicher Parameterwerte verarbeitet werden,
- Bestimmen der Prozessgrenzen durch eine Abfolge von Verfahrensschritten, umfassend: Erzeugen eines latenten Vektorraums durch Trainieren eines unüberwachten generativen maschinellen Lernalgorithmus auf der Grundlage eines oder mehrerer der Bilder des Datensatzes,
- Auswählen eines oder mehrerer Abfragebilder aus dem Bilddatensatz,
- für jedes Abfragebild, Bestimmen der Abstände im latenten Vektorraum vom Abfragebild zu einer Vielzahl von Bildern aus dem Datensatz, wobei die letztere Vielzahl von Bildern im Folgenden als Objektbilder bezeichnet wird,
- Zuweisen einer Bewertung zu jedem der Objektbilder basierend auf den Abständen zwischen der Vielzahl von Objektbildern und dem einen oder den mehreren Abfragebildern, wobei die Abfragebilder, die Objektbilder und die Definition der Bewertung derart gewählt werden, dass die Punktzahl zumindest in einem gegebenen Bereich des einen oder der mehreren Merkmale repräsentativ für das eine oder die mehreren Merkmale der Bilder ist,
- Extrahieren der Prozessgrenzen aus der Beziehung zwischen der Bewertung und dem einen oder den mehreren Prozessparametern.

2. Verfahren nach Anspruch 1, wobei ein einzelnes Abfragebild ausgewählt wird und wobei die Bewertung der Abstand oder eine lineare Funktion davon ist.

3. Verfahren nach Anspruch 1, wobei mehrere Abfragebilder ausgewählt werden und wobei die Bewertung eine Gesamtbewertung basierend auf der Gesamtheit der Bewertungen für jedes Objektbild ist.

4. Verfahren nach Anspruch 3, wobei die Gesamtbewertung das Maximum der Bewertungen jedes der Objektbilder ist.

5. Verfahren nach Anspruch 3, wobei die Gesamtbewertung der Mittelwert der Bewertungen jedes der Objektbilder ist.

6. Verfahren nach einem der Ansprüche 3 bis 5, wobei ein oder mehrere synthetische Bilder, die von dem Algorithmus erzeugt werden, zu dem Datensatz hinzugefügt werden und wobei eines oder mehrere der synthetischen Bilder als Abfragebilder verwendet werden.

7. Verfahren nach einem der vorstehenden Ansprüche, wobei mindestens eines der Abfragebilder und/oder mindestens eines der Objektbilder ein Ausreißerbild, d. h. ein Bild ist, das nicht den Werten des einen oder der mehreren Merkmale entspricht, die in einem vordefinierten Interessenbereich für das eine oder die mehreren Merkmale liegen.

8. Verfahren nach einem der vorstehenden Ansprüche, wobei der maschinelle Lernalgorithmus ein Algorithmus des Typs Generative Adversarial Network (GAN) oder Variational Auto Encoder (Var-AE) ist.

9. Verfahren nach einem der vorstehenden Ansprüche, wobei das Verfahren ein Lithographieprozess ist, wobei das Verfahren zum Bestimmen eines druckbaren Fensters hinsichtlich der im Lithographieprozess angewendeten Dosis und des Fokus verwendet wird, und wobei die Grenzen des druckbaren Fensters durch Bestimmen einer Stufe in der Relation zwischen der Bewertung und der Dosis und/oder dem Fokus erkannt werden.

10. Verfahren nach einem der Ansprüche 1 bis 8, wobei das Verfahren zum Bestimmen eines Prozessfensters für einen oder mehrere Parameter des Prozesses verwendet wird und wobei die Prozessfensterbestimmung auf einer vordefinierten bekannten Beziehung zwischen den Bewertungen und dem einen oder den mehreren Merkmalen der Bilder basiert.

11. Verfahren nach Anspruch 10, wobei die vordefinierte bekannte Beziehung auf einem oder mehreren Kalibrierungsschritten basiert, die vor der Durchführung des Verfahrens durchgeführt werden.

12. Verfahren nach einem der vorstehenden Ansprüche, wobei das eine oder die mehreren Merkmale der Bilder die kritische Dimension eines oder mehrerer 2- oder 3-dimensionaler Mustermerkmale, die in den Bildern erscheinen, umfassen.

13. Einrichtung zum Bestimmen von Prozessgrenzen gemäß dem Verfahren nach einem der vorstehenden Ansprüche, wobei die Einrichtung einen Computer umfasst, der konfiguriert ist zum:
- Empfangen der Bilder des Datensatzes,
- Trainieren des Algorithmus auf der Grundlage eines oder mehrerer der Bilder,
- Berechnen des Abstands im latenten Vektorraum zwischen einem oder mehreren Abfragebildern und einer Vielzahl von Objektbildern,
- Berechnen der Bewertung basierend auf den Abständen,
- Extrahieren der Prozessgrenzen.

14. Computerprogrammprodukt, das in einer Einrichtung nach Anspruch 13 anwendbar ist und konfiguriert ist zum
- Empfangen der Bilder des Datensatzes,
- Trainieren des Algorithmus auf der Grundlage eines oder mehrerer der Bilder,
- Berechnen des Abstands im latenten Vektorraum zwischen einem oder mehreren Abfragebildern und einer Vielzahl von Objektbildern,
- Berechnen der Bewertung basierend auf den Abständen,
- Extrahieren der Prozessgrenzen.
wenn das Programmprodukt auf dem Computer ausgeführt wird.

## Revendications

1. Procédé de détermination de limites de traitement pour un ou plusieurs paramètres d'un traitement de semi-conducteur, le procédé comprenant les étapes consistant à :
- fournir un ou plusieurs substrats de test comprenant une pluralité de surfaces de puce (1),
- appliquer le traitement sur différentes zones de puce des un ou plusieurs substrats de test, dans lequel les un ou plusieurs paramètres de traitement sont incrémentés, en commençant par une valeur établie des paramètres au niveau de l'une des zones de puce, et en augmentant et/ou diminuant le paramètre ou les paramètres par étapes dans les autres surfaces de puce,
- obtenir un ensemble de données d'images (3a, 3b, 3c) de la même partie des différentes zones de puce, traitées en appliquant différentes valeurs de paramètres,
- déterminer les limites de traitement par une séquence d'étapes de procédé comprenant : une création d'un espace vectoriel propre en effectuant l'apprentissage d'un algorithme d'apprentissage automatique génératif non supervisé sur la base d'une ou plusieurs des images de l'ensemble de données,
- sélectionner une ou plusieurs images d'interrogation à partir de l'ensemble de données d'image,
- pour chaque image d'interrogation, déterminer les distances dans l'espace vectoriel propre de l'image d'interrogation à une pluralité d'images provenant de l'ensemble de données, cette dernière pluralité d'images étant appelée ci-après images d'objet,
- attribuer un score à chacune desdites images d'objet, sur la base des distances entre ladite pluralité d'images d'objet et les une ou plusieurs images d'interrogation, dans lequel les images d'interrogation, les images d'objet et la définition du score sont choisies de telle manière que le score soit représentatif des une ou plusieurs caractéristiques des images, au moins dans une plage donnée desdites une ou plusieurs caractéristiques,
- extraire les limites de traitement de la relation entre le score et les un ou plusieurs paramètres de traitement.

2. Procédé selon la revendication 1, dans lequel une seule image d'interrogation est sélectionnée, et dans lequel le score est ladite distance ou une fonction linéaire de celle-ci.

3. Procédé selon la revendication 1, dans lequel de multiples images d'interrogation sont sélectionnées, et dans lequel le score est un score agrégé basé sur la totalité des scores pour chaque image d'objet.

4. Procédé selon la revendication 3, dans lequel le score agrégé est le maximum des scores de chacune des images d'objet.

5. Procédé selon la revendication 3, dans lequel le score agrégé est la moyenne des scores de chacune des images d'objet.

6. Procédé selon l'une quelconque des revendications 3 à 5, dans lequel une ou plusieurs images synthétiques, générées par l'algorithme, sont ajoutées à l'ensemble de données, et dans lequel une ou plusieurs desdites images synthétiques servent d'images d'interrogation.

7. Procédé selon l'une quelconque des revendications précédentes, dans lequel au moins une des images d'interrogation et/ou au moins une des images d'objet est une image aberrante, c'est-à-dire une image qui ne correspond pas à des valeurs des une ou plusieurs caractéristiques qui s'inscrivent dans une plage d'intérêt prédéfinie pour lesdites une ou plusieurs caractéristiques.

8. Procédé selon l'une quelconque des revendications précédentes, dans lequel l'algorithme d'apprentissage automatique est un algorithme du type réseau antagoniste génératif (GAN) ou auto codeur variationnel (Var-AE).

9. Procédé selon l'une quelconque des revendications précédentes, dans lequel le traitement est un traitement lithographique, dans lequel le procédé est utilisé pour déterminer une fenêtre imprimable en termes de dose et de mise au point appliquées dans le traitement lithographique, et dans lequel les limites de la fenêtre imprimable sont détectées en déterminant une étape dans la relation entre le score et la dose et/ou la mise au point.

10. Procédé selon l'une quelconque des revendications 1 à 8, dans lequel le procédé est utilisé pour déterminer une fenêtre de traitement pour un ou plusieurs paramètres du traitement, et dans lequel la détermination de fenêtre de traitement est basée sur une relation connue prédéfinie entre les scores et lesdites une ou plusieurs caractéristiques des images.

11. Procédé selon la revendication 10, dans lequel la relation connue prédéfinie est basée sur une ou plusieurs étapes d'étalonnage réalisées avant de réaliser le procédé.

12. Procédé selon l'une quelconque des revendications précédentes, dans lequel les une ou plusieurs caractéristiques des images comprennent la dimension critique d'un ou plusieurs attributs de modèle en 2 ou 3 dimensions apparaissant dans les images.

13. Appareil de détermination de limites de traitement conformément au procédé selon l'une quelconque des revendications précédentes, l'appareil comprenant un ordinateur configuré pour :
- recevoir les images de l'ensemble de données,
- effectuer l'apprentissage de l'algorithme sur la base d'une ou plusieurs desdites images,
- calculer la distance dans l'espace vectoriel propre entre une ou plusieurs images d'interrogation et une pluralité d'images d'objet,
- calculer ledit score sur la base desdites distances,
- extraire les limites de traitement.

14. Produit programme d'ordinateur applicable dans un appareil selon la revendication 13, et configuré pour
- recevoir les images de l'ensemble de données,
- effectuer l'apprentissage de l'algorithme sur la base d'une ou plusieurs desdites images,
- calculer la distance dans l'espace vectoriel propre entre une ou plusieurs images d'interrogation et une pluralité d'images d'objet,
- calculer ledit score sur la base desdites distances,
- extraire les limites de traitement
lorsque le produit de programme tourne sur l'ordinateur.
